(19) Europäisches Patentamt European Patent Office Office européen des brevets

(11) **EP 2 369 768 B1**

(12) **EUROPEAN PATENT SPECIFICATION**

(45) Date of publication and mention of the grant of the patent:
**08.10.2014 Bulletin 2014/41**

(51) Int Cl.:
*H04L 1/00* (2006.01)  *H04N 21/438* (2011.01)
*H04N 21/4385* (2011.01)  *H04N 21/2389* (2011.01)
*H04N 21/2383* (2011.01)  *H04N 21/643* (2011.01)

(21) Application number: **11150035.1**

(22) Date of filing: **03.01.2011**

(54) **Method of transmitting data**

Verfahren zur Datenübertragung

PROCÉDÉ POUR LA TRANSMISSION DE DONNÉES

(84) Designated Contracting States:
**AL AT BE BG CH CY CZ DK EE ES FI FR GB GR HR HU IE IS IT LI LT LU LV MC MK MT NL NO PL PT RO RS SE SI SK SM TR**

(30) Priority: **04.01.2010 DE 102010004015**

(43) Date of publication of application:
**28.09.2011 Bulletin 2011/39**

(73) Proprietor: **Deutsches Zentrum für Luft- und Raumfahrt e.V.**
**51147 Köln (DE)**

(72) Inventor: **Boussemart, Vincent**
**81241 München (DE)**

(74) Representative: **Von Kreisler Selting Werner - Partnerschaft**
**von Patentanwälten und Rechtsanwälten mbB**
**Deichmannhaus am Dom**
**Bahnhofsvorplatz 1**
**50667 Köln (DE)**

(56) References cited:
**EP-A1- 1 732 235    US-A1- 2009 055 715**

• **ETSI: "Digital Video Broadcasting (DVB) MPE-IFEC", DVB STANDARD,, no. A131, 1 November 2008 (2008-11-01), pages 1-36, XP002547119,**

**Description**

The invention is related to a method of transmitting data from a transmitter to a receiver, in particular in a DVB-Scenario.

In the following different mechanisms and optimizations that can be used preferably in Multi-Protocol Encapsulation (MPE) - inter-burst Forward Error Correction (iFEC) Receivers for decoding are presented.

The transmission of data is performed according to "Digital Video Broadcasting (DVB); DVB specification for data broadcasting, ETSI EN 301 192 V1.4.2, April 2008" in bursts: an amount of data is inserted in the physical layer according to a given duration. On the one hand Multi-Protocol Encapsulation - Forward Error Correction was defined in order to add redundancy information within a given burst. The content of the burst is protected and if some losses occur data can be recovered. MPE-FEC is able to recover from fade events which are in the order of hundreds milliseconds. MPE-FEC is used for instance in Digital Video Broadcasting - Terrestrial (DVB-T) as described in "Framing structure, channel coding and modulation for digital terrestrial television, ETSI EN 300 744 V1.6.1, Jan. 2009". On the other hand, when considering a reception using a satellite segment fade events become more critical. Shadowing can occur (element between the satellite and the terminal) and the duration and the frequency of the fade events depend on the terminal position. When considering a mobile terminal fade events are in the order of several seconds. As specified previously MPE-iFEC means MPE - inter-burst FEC, i.e. the redundancy is computed and distributed over several time-slice bursts and this directly increases the interleaver duration. When MPE-FEC is able to recover fade events which are in the order of hundred milliseconds, MPE-iFEC can recover fade events which are in the order of several seconds.

MPE-iFEC is used for receiving data on a mobile terminal while using a satellite transmission. The corresponding standard is the Digital Video Broadcasting - Satellite Handheld (DVB-SH) as described in "Framing Structure, channel coding and modulation for Satellite Services to Handheld devices (SH) below 3 GHz, ETSI EN 302 583 V1.1.1, July 2007" and will be considered from now on in the present application.

First, the mechanisms and optimizations that can be used in DVB-SH Receivers which are compliant with MPE-iFEC are described. Data is transmitted and is received by the terminals in bursts.

Data is generated by the application and encapsulated by the transport layer. It can be for instance a video encapsulated over the Real-Time Protocol (RTP) and the User Datagram Protocol (UDP). The packets issued from the application/transport layers are then forwarded to the Internet Protocol (IP) in order to be encapsulated. IP datagrams produced by the IP layer are transmitted to the Multi-Protocol Encapsulator (MPE) where a header (12 bytes) and a trailer (4 bytes, CRC check) are added. The next layer is responsible of the signaling and of the iFEC part, Actually according to some mechanisms which are described in "Guidelines for Implementation for Satellite Services to Handheld devices (SH) below 3GHz, ETSI TS 102 584 V1.1.1, Dec. 2008" data (MPE sections) is collected and redundancy is produced. The redundant data is encapsulated into MPE-iFEC sections and signaling is added into the header of each MPE-iFEC section so that the Receiver can handle them. The MPE-IFEC sections are finally distributed over different bursts. A burst is composed of the MPE sections containing the IP packets belonging to this burst and of the MPE-iFEC sections which were built taking into account data from different bursts (mechanisms described in "MPE-IFEC, Draft TS 102 772 V1.1.1, DVB BlueBook A131, Nov. 2008"). Before being modulated and transmitted the sections are finally encapsulated into MPEG - Transport Stream (TS) packets which have a 5 or 4 bytes header and respectively 183 or 184 bytes payload.

The purpose of the Receiver is to reorganize correctly all sections (MPE and MPE-iFEC), to decode data and redundancy and to recover the IP datagrams. As specified previously during the transmission fade events can occur meaning that some parts of the burst, and / or one or several bursts, can be lost.

The data part of a burst that is built with the IP datagrams is not necessarily completely filled. This is mainly due to the time limitation related to the burst construction. For this reason the beginning of the Application data subtable (ADST) is filled with IP datagrams but not necessarily the end. The capacity of the decoder to successfully retrieve original data depends on the number of columns that are with "errors" and reciprocally that are "error free".

The state of the art according to "Guidelines for Implementation for Satellite Services to Handheld devices (SH) below 3GHz", ETSI TS 102 584 V1.1.1, Dec. 2008 and MPE-IFEC, Draft TS 102 772 V1.1.1, DVB BlueBook A131, Nov. 2008, describes a Reed Solomon (RS) decoder (255,191) integrated in an MPE-iFEC receiver. When receiving a burst the MPE-iFEC Receiver analyses its content. A burst is composed of MPEG-TS packets which encapsulate different sections. These sections can contain data (MPE sections) or redundancy (MPE-FEC or MPE-iFEC sections). It is considered that a burst is composed of both MPE sections and MPE-iFEC sections. The burst thus contains data and redundancy which is computed from interleaved data and distributed over several bursts.

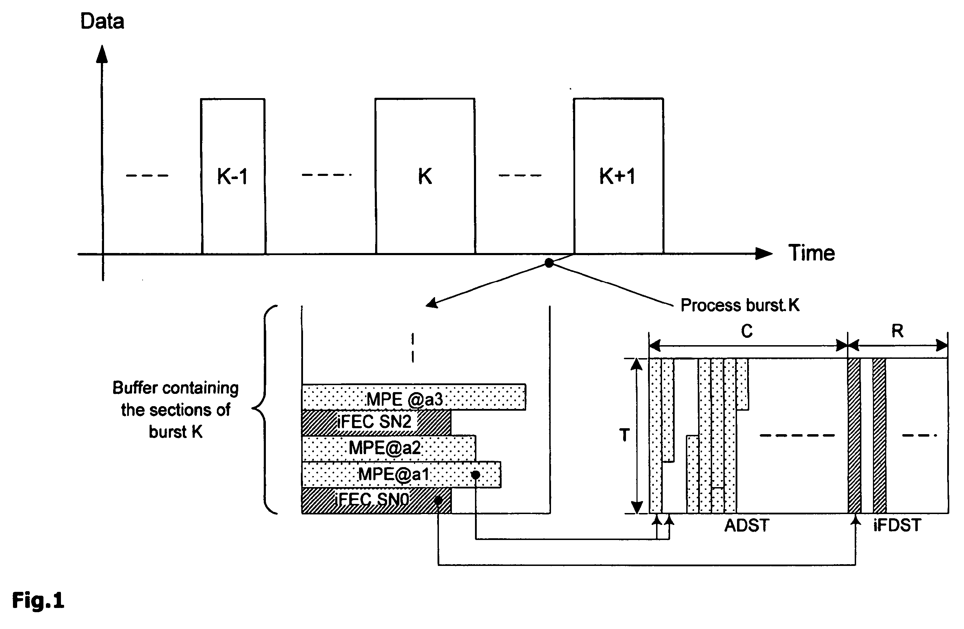

Next the mapping of the burst into ADST and iFDST is described. Once the burst is correctly detected, the MPE-iFFC Receiver has to extract the sections and to distribute the content of each section (that is the payload) into the tables. The data part (encapsulated in the MPE sections) has to be placed into the Application Data Sub-Table (ADST) and the redundancy part (encapsulated in the MPE-iFEC sections) in the iFEC Data Sub-Table (iFDST) (Figure 1).

MPE sections carry in their headers information about the address. The address corresponds to the position of the MPE section payload (more particularly the first byte) into the ADST as described in "MPE-IFEC, Draft TS 102 772 VL1.1.1, DVB BlueBook A131, Nov. 2008". It permits to determine the column and the row at which the payload should be placed. The address field of the MPE section header is useful since some MPE sections may be lost within a burst.

The MPE-iFEC Receiver thus processes all the MPE sections of a burst and places their content (payload) into the ADST according to the address indicated by the header. The size of the ADST is determined by the parameters C and T which are respectively the maximum number of data columns per ADST and the symbol size of code (number of rows).

In the example given by Figure 1 the MPE section having the address "a1" ("MPE @ a1") is mapped at the beginning of the ADST. The next MPE section has the address "a2" ("MPE @ a2") is not mapped directly after the first section: one or several MPE sections were lost and a gap appears in the ADST.

MPE-iFEC sections further carry in their headers information about the section number. The section number allows the receiver to determine the position of the MPE-iFEC section payload into the iFDST. The section number indicated by the MPE-iFEC section header is useful since some MPE-iFEC sections may be lost within a burst.

The MPE-iFEC Receiver thus processes all the MPE-iFEC sections of a burst and places their content (payload) into the iFDST according to the section number indicated by the header. The size of the iFDST is determined by the parameters R and T which are respectively the maximum number of iFEC sections in an iFEC burst and the symbol size of code (number of rows). Actually the payload size of the MPE-iFEC sections corresponds directly to the parameter T meaning that the content is completely placed into a column of the iFDST.

In the example depicted by Figure 1 the first iFEC section has the sequence number "0" which indicates to the Receiver that it has to be placed in the first column of the iFDST. The next MPE iFEC has the sequence number "2", it is thus placed into the third column of the iFDST: an iFEC section is missing and a gap appears in the iFDST.

The data part of a burst is not necessarily completely filled, This is mainly due to the time limitation related to the burst construction. For this reason the beginning of the Application Data Sub-Table (ADST) is filled but not necessarily the end.

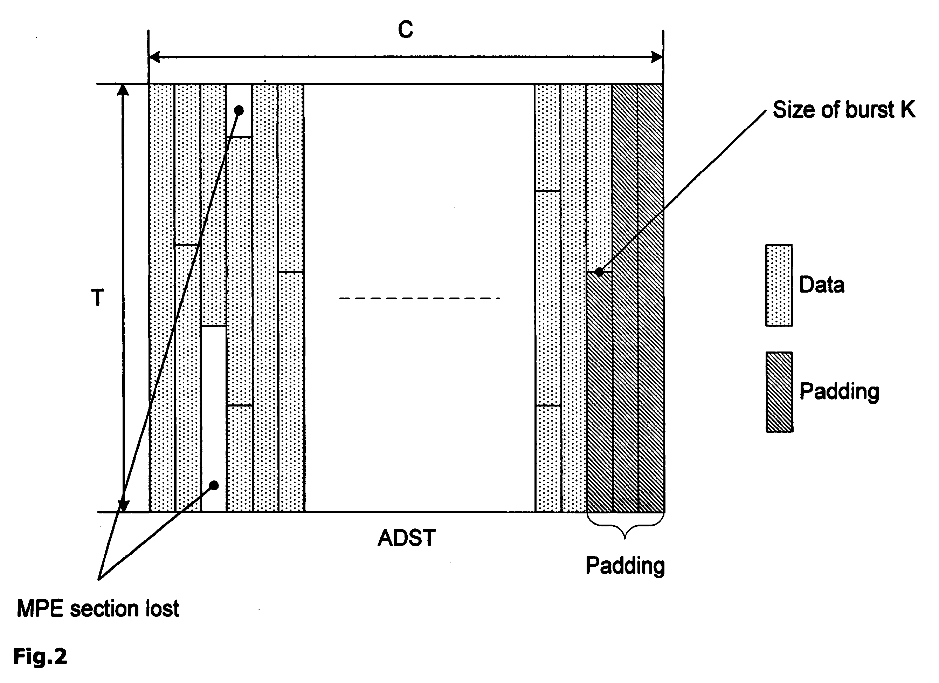

Therefore, a padding containing no data is present in the ADST. The burst size of a burst is indicated by the previous burst size field present in the header of each MPE-iFEC section present in different bursts. If the burst size of a burst is known, the size of the padding within the burst, namely the data-free area, is known. Therefore, it is possible to recover the padding information so that the MPE-iFEC Receiver can fill the last columns of the ADST with padding (Figure 2).

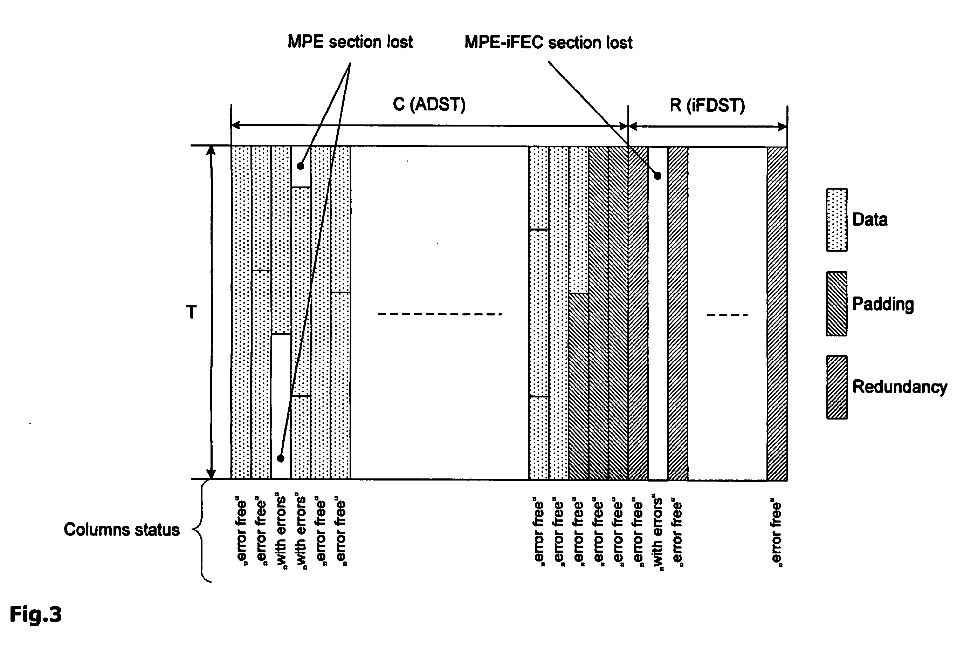

When the content of all MPE sections and MPE-iFEC sections is placed respectively into the ADST and the iFDST, and optionally the padding (if the size of the current burst is known), the MPE-iFEC Receiver determines the status of each column which can be "error free" and "with errors". If a column was completely filled then its status is "error free". On the contrary if a column was not completely filled then information is missing and its status is "with errors" (Figure 3).

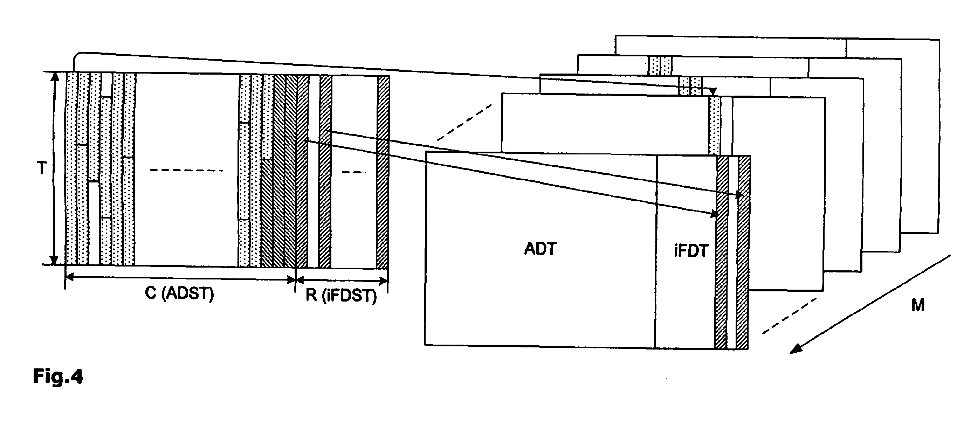

Next the mapping of the ADST and iFDST into ADT's and IFDT's is described. Once all the sections received during the burst are mapped into the ADST and the iFDST each column of the two tables are respectively mapped in the Application Data Tables (ADTs) and the iFEC Data Tables (iFDTs). The number of ADT and iFDT depends on the parameter M which is defined as the number of concurrent ADT and iFDT (Figure 4).

The content of each column of the ADST is copied into different columns of the ADTs. The index $m$ of the ADT (there are $M$ ADTs) is computed using a formula which depends on the current datagram burst number $k$, the column index $j$ to be mapped, the parameter $B$, that is the iFEC data interleaving parameter, and the parameter $M$.
$m= (k+j[B])[M]$ where $[\ ]$ is the modulo operator.

The column index ($adt\_column$) of the ADT in which the current column $j$ of the ADST has to be placed is obtained using a formula taking into account the parameter $B$, the parameter $C$ and the current column index $j$.

$$adt\_column = \left(B - \left(j[B]+1\right)\right) \times \lfloor C/B \rfloor + \max\left(0, C[B] - \left(j[B]+1\right)\right) + \lfloor j/B \rfloor$$

where $\lfloor\ \rfloor$ is the floor operator and $\max(\ )$ the maximum operator.

The content of each column of the iFDST is copied into different columns of the iFDTs. The index $m$ of the iFDT (there are M iFDTs) is computed using a formula which depends on the current burst number $k$, the column index $j$ to be mapped, the parameter $S$, that is the iFEC spread parameter, and the parameter $M$.
$m=(k-j[S]-1+M)[M]$ where $[\ ]$ is the modulo operator.

The column index of the iFDT in which the current column of the iFDST has to be placed is directly.

The MPE-iFEC Receiver also copies the status of the columns while mapping the ADST and the iFDST into ADTs and iFDTs. In that way the Reed-Solomon decoder can determine before starting the decoding process what is the column error pattern in the input matrices (which is a given ADT and iFDT).

As soon as the content of both ADST and iFDST is copied into different ADTs and iFDTs both Data Sub-Tables can be cleaned in order to receive the content of another burst. All rows of each column in both tables are thus reset so that it does not contain information from previous bursts. The status of each column is also reset and assumed as "with errors" by default.

Next the decoding process is described. The decoding process is performed on a particular set of ADT and iFDT (thus on a specific index of the M ADTs and iFDTs). The content of the ADT corresponds to the data part and the content of the IFDT to the redundancy part.

The Reed-Solomon decoder used in the MPE-iFEC Receiver (RS (255, 191)) is able to recover completely from errors if and only if the number of columns "with errors" in the input matrices is smaller or equal to the number of redundancy columns which is 255 - 191 = 64. If the number of erroneous column is thus smaller or equal to 64 the RS decoder will be able to recover all columns "with errors" and mark them as "error free". On the contrary if the number of erroneous column is greater than 64 then the decoding process does not need to be started since the RS decoder will not be able to recover from errors. In that case the content of the columns is unchanged and their status also.

Once the decoding processed was performed on a given set of ADT and iFDT the data part can be copied back into ADSTs.

Actually at the transmission side the data to be sent was distributed among B ADTs, B being the iFEC data interleaving parameter. The content of the current ADT was thus issued from B ADSTs. For this reason at the receiver side the content of the ADT has to be distributed back into B ADSTs.

The same principle as for mapping the content of the ADST to ADTs is used: the content of each column of the ADT is copied into different columns of B ADSTs. The status of each column is also copied so that the Receiver can determine the error pattern of the output ADST.

After having mapped the content of the ADT the corresponding set of ADT and iFDT is cleaned so that it can receive the content of other bursts. All rows of each column in both tables are thus reset to that it does not contain information from previous bursts. The status of each column is also reset and assumed as "with errors" by default.

Next the processing of the ADST is described. Once an ADST was filled by B ADTs, it is selected among the B ADSTs available in order to be processed, i.e. so that the content of the ADST can be extracted. The ADST contains the original data that was transmitted and possibly recovered from errors. The ADST generally contains data in a specific format that allows the Receiver to take out easily (IP packets for instance).

The output ADST can contain data packets, for example IP packets. In such a case the content of the IP header allows the Receiver to determine the length of the IP packet so that it can continue extracting the rest of the ADST.

The Receiver can check the status of the columns into which the IP packet is located in order to be able to determine whether or not the IP packet is correct. For instance if the IP packet the Receiver is processing is distributed over 3 columns and the column in the middle is wrong then the IP packet contains error and can be discarded. The Receiver moves the pointer to the next IP packet in the ADST and continues the processing. Checking the status of each column allows the Receiver to process and extract only IP packets which are stored into columns that are "error free". Doing that ensures the delivery of IP packets that are correct from the first byte to the last one. However for some error patterns such verification will force the Receiver to discard IP packets even if they are correct.

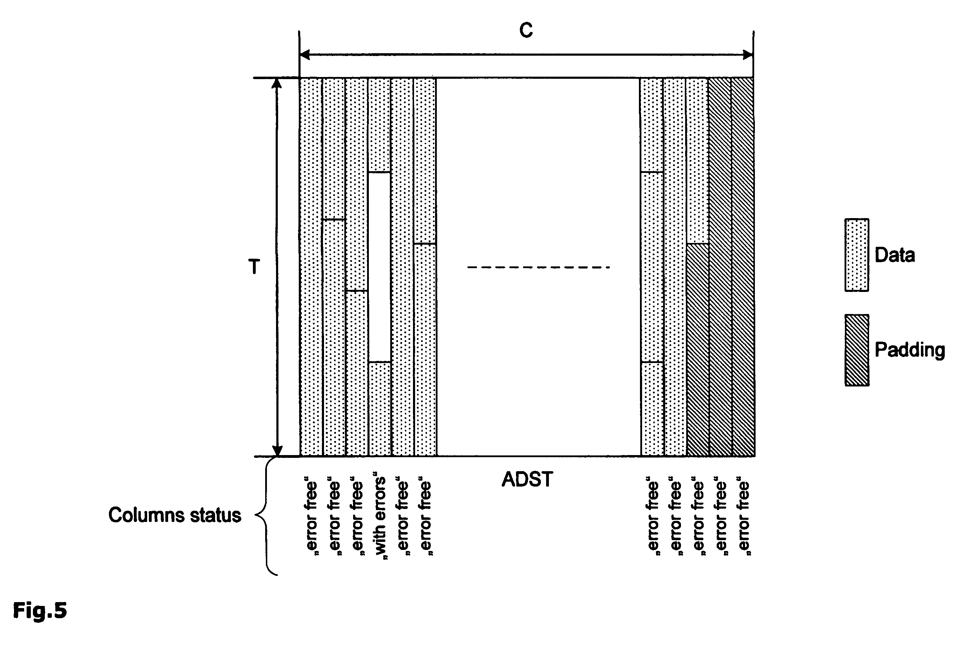

In the example shown in Figure 5 the Receiver will start processing the first IP packet and since the first two columns are "error free" the IP packet can be extracted. The Receiver then processes the second IP packet and since both second and third columns are "error free" the IP packet can also be extracted. The problem appears with the next IP packet. Here a small IP packet is missing and for this reason the fourth column is marked as "with errors". The Receiver will discard the third IP packet (and also the next one if processed) whereas it is actually correct.

It has to be remarked that such problem does not only appear when the ADST contains IP packets exclusively. Other kind of payload will involve the same issues. IP packets were just considered as an example in order to better explain the problem. Such a problem will occur with each payload which is divided into data packets.

The Receiver can also check the first byte it is pointing in the ADST in order to determine if the padding part of the ADST is reached or not. Again if the ADST contains IP version 4 packets the Receiver can check if the first byte pointed is 0x45 or 0x46 which correspond to the first byte of an IP packet version 4 respectively with a 20 bytes header or 24 bytes header. If the pointed byte does not correspond then the ADST contains error or the padding part of the ADST is reached.

Without knowledge of the data length pointed in the ADST the Receiver cannot determine in which column and row of the ADST it has to point next in order to continue processing the rest of the ADST. This issue involves the Receiver to stop the processing of the ADST. If only a small part of the ADST is wrong then even if the rest of the ADST is correct its content cannot be recovered. One possible solution would be to look for the next pattern 0x45 or 0x46 in the ADST but such pattern does not correspond necessarily to the first byte of an IP packet.

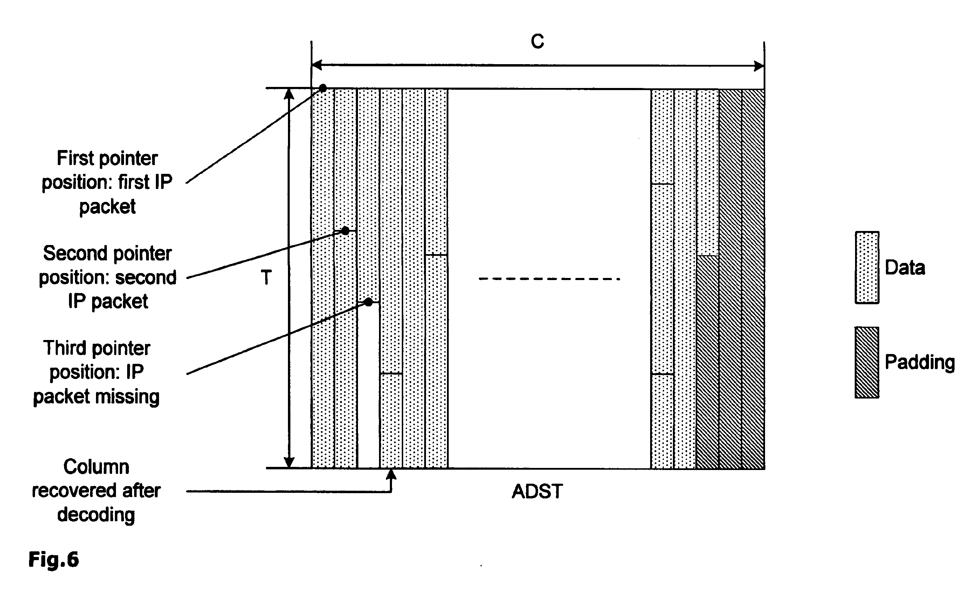

The example depicted by Figure 6 shows the problem. While processing the ADST the first pointer is placed at the beginning of the ADST (first column, first row) and thus points the first byte of the first IP packet. The first byte will match the pattern 0x45 or 0x46. The Receiver analyses the content of the IP header in order to compute the length of the IP packet. Once the first IP packet is processed the Receiver moves the pointer to the next IP packet. The pointer is now placed at the beginning of the second IP packet which can also be processed. The problem appears when updating again the pointer: the byte analysed by the Receiver does not match the pattern and since the column was not recovered by the decoder (to many erroneous columns in the corresponding ADT/iFDT set) the Receiver cannot determine the size of the IP packet missing. The Receiver will stop processing the ADST and thus will discard the rest of the ADST. The Receiver cannot look for the next pattern (0x45 or 0x46) since the next column was recovered. The next column contains a part of the IP packet and may contain such pattern but which will not correspond to the beginning of the IP packet.

It has to be remarked that such problem does not only appear when the ADST contains IP packets exclusively. Other kind of payload will involve the same issues. IP packets were just considered as an example in order to better explain the problem.

Document - ETSI: "Digital Video Broadcasting (DVB) MPE-IFEC", DVB STANDARD, no. A131, 1 November 2008 (2008-11-01), pages 1 - 36, XP002547119 - defines the DVB MPE-IFEC-STANDARD, wherein MPE-packets are written into the ADST beginning at respective begin addresses transmitted with the packets. When a packet is lost, a gap results in the ADST. As packet length information stored with a packet is missed due to the lost packet, the begin addressed of a next packet in the ADST after the gap cannot be calculated and processing is only possible up to the last error free packet before the gap.

It is an object of the present invention to provide for a method of transmitting data, whereby data recovery during the processing of the output ADST shall be improved.

According to the invention this object is achieved by the features of method claim 1.

In a method of transmitting data from a transmitter to a receiver, in particular in a DVB-scenario, data is transmitted in consecutive bursts and each burst comprises a plurality of Multi-Protocol Encapsulation (MPE) and Multi-Protocol Encapsulation inter-burst Forward Error Correction (MPE-iFEC) sections.

It is preferred that MPE-sections carry for example in their header an ADST-address containing the position in the ADST into which the content of the respective MPE-section has to be written.

According to the invention this ADST-address is stored into the ADST while mapping the content of a burst in the ADST and iFDST. As an alternative or in addition to the ADST-address the status of each byte can be stored in the ADST, whereby the status of each byte is marked as "error free" or "with errors".

The ADST-address and/or the byte status is further written in the ADT's while mapping the content of the ADST into ADT's, so that the ADST-address and/or the byte status is conveyed from the ADST to the ADT's.

After the decoding process is applied on the ADT's and iFDT's the following steps are performed if the byte status has been stored in the ADT's: The byte status is updated by the receiver by the following steps:

- Checking whether a byte which has been labeled before decoding as "with errors" is present in a column whose status has changed from "with errors" before decoding to "error free" after decoding.

- Changing the status of such a byte from "with errors" to "error free".

If the byte status has not been stored in the ADT's (namely after copying the byte status from the ADST) the last mentioned method steps can be omitted. This is the case when only the ADST-address is stored according to the inventive method.

The inventive method further comprises the following step: The updated byte status and/or the ADST-address stored in the ADT's is copied into the output ADST's.

Since only the data part is relevant after decoding and while processing the output ADST, the byte status needs only to be stored for the ADST. It is preferred to store the status of the byte for each row of each column.

In a preferred embodiment, while processing an output ADST the receiver checks the status of each byte, whereby if all bytes belonging to a data packet are "error free" the receiver starts processing this data packet and if at least one byte belonging to a data packet is "with errors" this data packet is discarded.

It is further preferred that the status of each byte is marked as "with errors" when initializing the ADST and if a byte is mapped from a burst into the ADST the corresponding byte is marked as "error free".

With regard to the byte status it has to be considered that the decoding process may change the status of a column from "with errors" before decoding to "error free" after decoding. If the column is "error free" then all byte status present in this column are marked as "error free". In that way the byte status of each row of each column is updated according to the outcome of the decoding process. After the byte status is copied into the output ADST's, the output ADST's contain in each row of each column the final byte status.

While processing an output ADST the receiver is now able to check the status of each byte. For example if all the bytes belonging to the same IP packet are correct (namely "error free") then the IP packet can be extracted. On the contrary if at least of all bytes belonging to the same IP packet is not correct (namely "with errors") then the IP packet is discarded. Therefore relying on the byte status instead of the column status increases the capacity of the receiver to determine more accurately which data packet is correct and which is not.

With regard to the use of the ADST-address it has to be considered that again only the data part is relevant after decoding and while processing the output ADST, so that the address is stored for the ADST only. As already explained with regard to the state of the art the address at which the payload has to be placed into the ADST is directly carried by the MPE-sections themselves. For each column of the ADST the addresses are stored: There can be no address at all in a column but also one or several addresses.

When the content of the ADST is mapped into ADTs the addresses present in each column of the ADST are also copied so that the information is conveyed before resetting the ADST and iFDST. Finally once the decoding process is performed, the addresses are copied into the output ADSTs. The output ADSTs thus contain in each column the list of addresses.

While processing an output ADST the Receiver is now able to move its pointer to the next address available even if there was an error while processing its content. The next address available can be the next one directly available in the same column or the first address available in the next columns.

Therefore by using the ADST-address according to the inventive method it is possible that the receiver continues processing further data packets after a gap appears in the output ADST, while a receiver according to the state of the art would discard the rest of the output ADST after a data packet is missing. Therefore for example if only a small part of the output ADST is wrong the receiver is able to recover the rest of the ADST which is correct, so that the recovery performance is improved.

In the following preferred embodiments of the invention are described in the context of the figures.

Figure 1 shows a mapping example of a burst in ADST and IFDST according to the state of the art,

Figure 2 shows the mapping of the burst in ADST and iFDST using a padding according to the state of the art,

Figure 3 shows an example of the column status in the mapping of the burst in ADST and iFDST according to the state of the art,

Figure 4 shows the mapping of the ADST and iFDST into ADT's and iFDT's,

Figure 5 is an example on how the column status is used in the state of the art,

Figure 6 is an example of the addressing problem as it appears in the state of the art,

Figure 7 is an example of the processing of the output ADST according to the invention using the byte recovery mechanism,

Figure 8 is an example of the processing of the output ADST according to the invention while using the address recovery mechanism,

Figure 9 is an example of the processing of the output ADST according to the invention while using both byte and address recovery mechanisms,

Figure 10 is a schematic overview of a simulation which has been performed,

Figure 11 shows the improvement of the mechanisms on the dump ID 1,

Figure 12 shows the improvement of the mechanisms on the dump ID 2,

Figure 13 shows the improvement of the mechanisms on the dump ID 3,

Figure 14 shows the improvement of the mechanisms on the dump ID 4,

Figure 15 shows the improvement of the mechanisms on the dump ID 5, and

Figure 16 shows the improvement of the mechanisms on the dump ID 6.

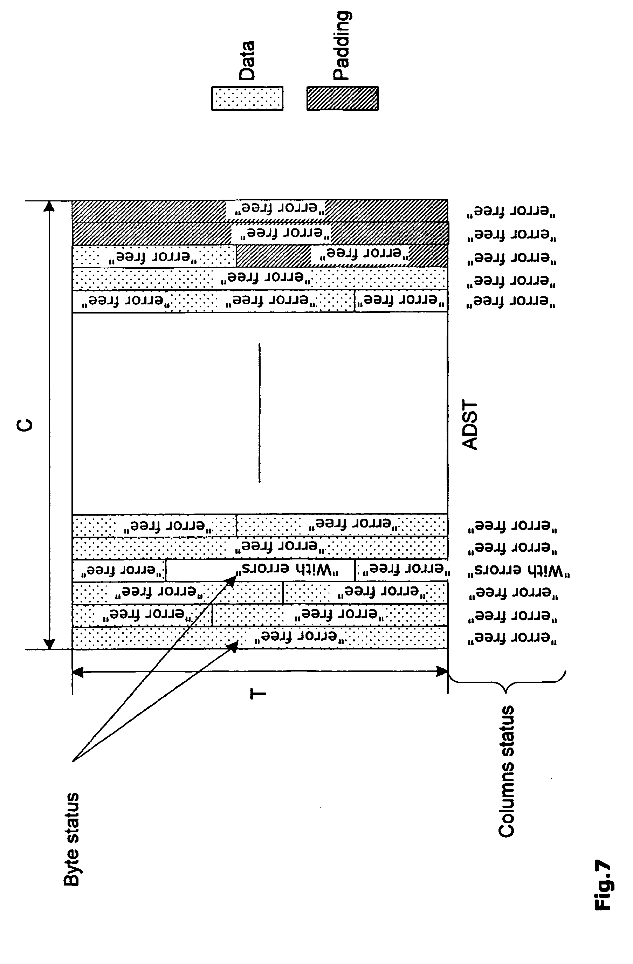

The example shown in Figure 7 describes the way the Receiver makes use of the Byte Recovery mechanism to better extract the data contained in the output ADST. In the example the Receiver processes the first two IP packets since there is no error in the ADST. The Receiver starts processing the third IP packet present in the output ADST and will verify the byte status of each byte belonging to this IP packet. Since all bytes are marked as "error free" the Receiver will extract this IP packet also.

Such mechanism does not depend on the content of the ADST meaning that it may contain something else than IP packets. IP packets are just used here as an example.

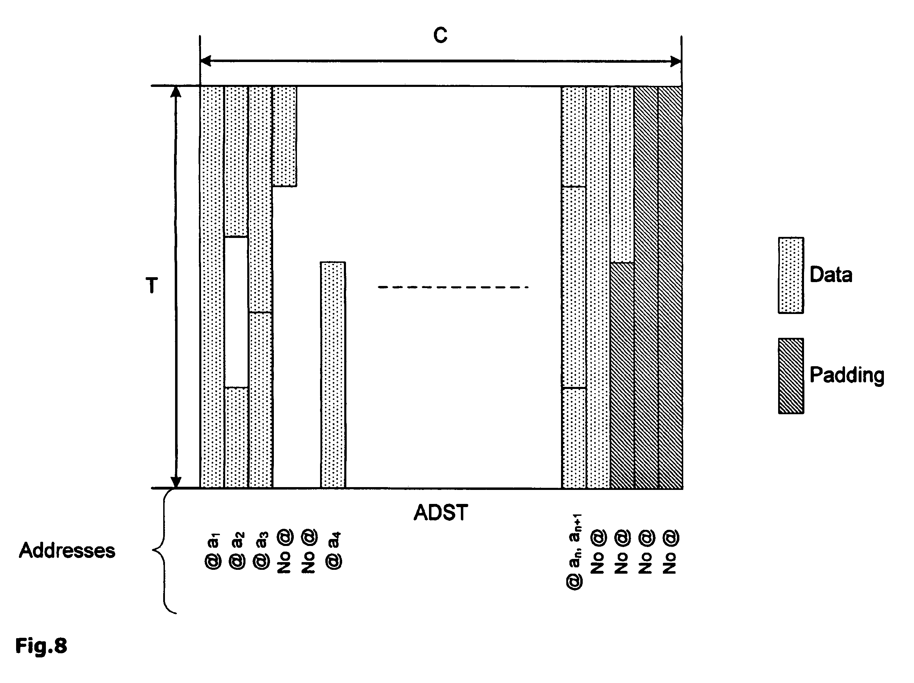

Figure 8 explains the principle of this mechanism based on an example. One can see that for each column of the output ADST there are addresses available. There can be no address at all ("No @") or one ("@ a1") or several addresses ("@ an, an+1"). The Receiver processes the first IP packet present in the output ADST. Since the packet is complete (no check of the column status in this case) it can be extracted. When the Receiver starts processing the second IP packet the first byte does not match the pattern since the MPE section containing the IP packet was not received correctly. Actually the second address is not available since the MPE section was not received (and thus the address field was not available). The Receiver moves the pointer to the next address available which is here located in the same column: "@ a2". The Receiver continues processing the next IP packet and the next one also until a gap appears again in the output ADST. In this case there is no address in the fourth and fifth columns (one or several MPE sections were not correctly received). The Receiver moves the pointer to the next address available which is located in the sixth column ("@ a4"). The Receiver can thus continue processing the content of the output ADST if addresses are available. It has to be remarked that the addresses are issued from the MPE sections once a burst was received. Addresses cannot be recovered by the decoding processing since the decoder does not know what is the content of each column (if it contains the beginning of an IP packet or not, etc.).

Such mechanism does not depend on the content of the ADST meaning that it may contain something else than IP packets. IP packets are just used here as an example.

Both Byte and Address Recovery mechanisms can be used conjointly in order to improve significantly the data recovery while processing the output ADST. Both mechanisms can be used separately but the best performances are obtained when they are both enabled.

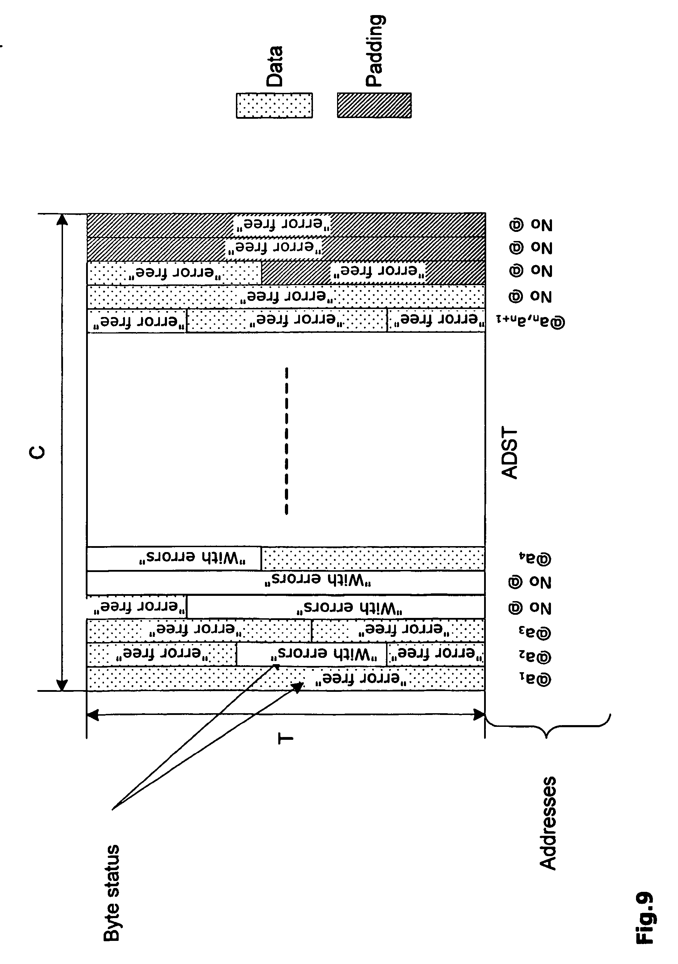

Figure 9 shows an example while processing the output ADST and using both Address and Recovery mechanisms at the same time. In such a case the Receiver is able to further improve the recovery of the data contained by the ADST.

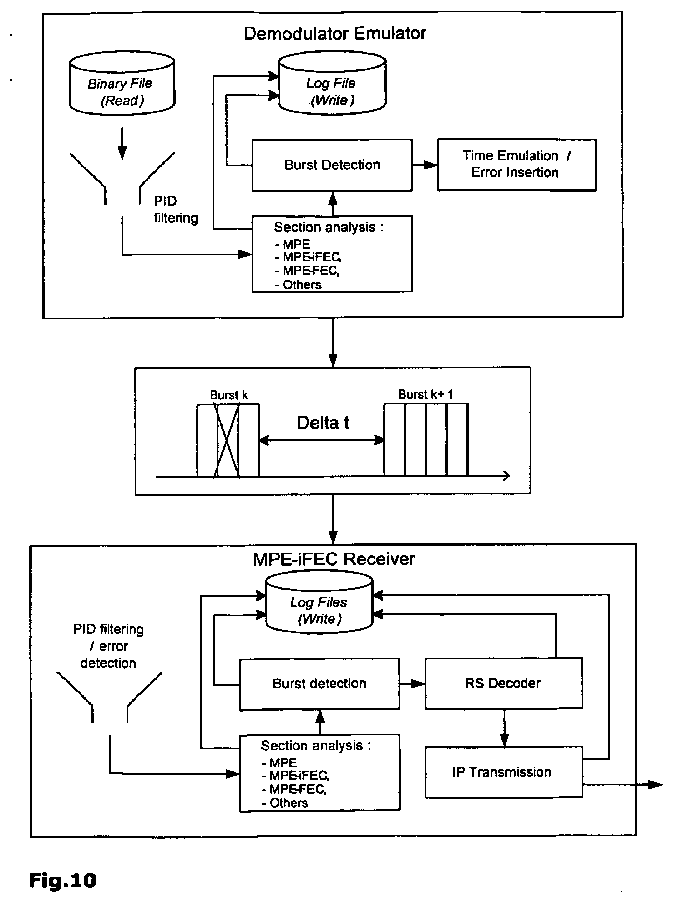

Simulations were performed using a Demodulator Emulator and the MPE-iFEC Receiver. The Demodulator Emulator reads as input a file containing a dump performed at the transport stream level (MPEG-TS packets). It considers the elementary stream (ES) of interest based on the MPEG-TS PID field. It can reproduce the time behavior of the bursts, i.e. data is transmitted during the burst duration but not between the end of a given burst (last byte) and the start of the next burst (first byte). For this purpose the Demodulator Emulator analyses the input stream. The Demodulator Emulator can introduce transmission errors which consists in setting the Transport Stream error indicator (field named "TS_error_ind") of the MPEG-TS header to "1" (1 = FEC error). Two kinds of errors can be simulated: random errors with a given probability and / or burst errors. Random errors consist in selecting randomly the MPEG-TS packets of the ES and to set the error flag. Burst errors consist in setting the flags of all MPEG-TS packets containing the MPE sections of the selected bursts to "1". Actually the burst numbers to be deleted are provided by the configuration file. The next figure (Figure 10) depicts the tested architecture used for the simulations.

It has to be remarked that the different input files used to perform the simulations are fully compliant with the standard and do not contain any errors. For this reason the IP stream that should be transmitted by the MPE-iFEC Receiver can be extracted directly from the input files used by the Demodulator Emulator. The IP streams can be compared with the IP streams issued from the MPE-IFEC Receiver. The Receiver should be able to recover from errors and thus reproduce the same IP stream. For some error patterns the capacity of the Receiver to recover from errors will be reached and errors will still be present in the IP transmission.

Different configurations were used in order to verify the performances of the MPE-iFEC Receiver. The following parameters are mainly affected:

- T: the symbol size of code (number of rows in ADST/iFDST/ADT/iFDT)
- C: the maximum number of data columns per ADST
- R: the maximum number of iFEC sections in an iFEC burst
- B: the iFEC data interleaving (number of matrices over which data is interleaved)
- S: the iFEC spread (number of matrices over which redundancy is interleaved)
- D: data delay at sender

For all the configurations and since the Reed-Solomon decoder is considered:

- EP: the encoding period MUST be set to 1.

- G: the maximum number of symbols per MPE-iFEC section MUST be set to 1.

Leading to the following:

- K: the number of columns per ADT is equal to K = EP x C = C
- N: the number of columns per iFDT is equal to N = EP x R x G = R

The next parameters are obtained based on the value of B, S, and D:

- M = B + max(0, S - D) + max(0, D - B)
- kMax = 256 - 256[M]

The next table (Table 1) summarizes the dumps and the corresponding configurations considered for the simulations. The three last columns indicate respectively how many bursts are present in the dump, the first burst ID detected and the number of IP packets transmitted in an error free environment.
The following table 1 shows a list of dumps and corresponding configurations considered for the simulations.

| Dumps ID | Receiver Parameters | | | | | | | Bursts | | IP |
| | PID | T | C | R | B | S | D | # | First ID | Total |
|---|---|---|---|---|---|---|---|---|---|---|
| 1 | 101 | 512 | 120 | 52 | 17 | 8 | 0 | 614 | 113 | 38172 |
| 2 | 102 | 512 | 120 | 52 | 17 | 8 | 25 | 615 | 148 | 38261 |
| 3 | 103 | 512 | 120 | 52 | 3 | 2 | 0 | 615 | 63 | 37895 |
| 4 | 104 | 256 | 120 | 52 | 17 | 8 | 0 | 615 | 228 | 21989 |
| 5 | 105 | 768 | 120 | 52 | 17 | 8 | 0 | 615 | 63 | 48178 |
| 6 | 101 | 1024 | 120 | 52 | 17 | 8 | 0 | 615 | 77 | 64941 |

The next table (Table 2) indicates for each configuration and each error pattern the capacity of the MPE-iFEC Receiver to recover from errors (number of columns and percentage) and the columns marked "with errors" in the output ADSTs (number of columns and percentage). One can see the impact of the error pattern and also of the configuration on the Decoder performance. The number of columns which are not "error free" in the output ADSTs will directly impact the processing their contents.
The following table 2 shows simulation results, namely number of columns "with errors" present in the output ADSTs.

| Dumps ID | Transmission Errors | | Decoder Recovery | | Output ADST Errors | |
| | Prob. MPEG-TS | Burst Errors | Columns | % | Column | % |
|---|---|---|---|---|---|---|
| 1 | 1,00% | 160,164,170,171 | 16951 | 88,30% | 2769 | 2,36% |
| | 2,00% | | 23544 | 88,38% | 3310 | 2,82% |
| | 3,00% | | 27216 | 81,44% | 5332 | 4,55% |
| | 4,00% | | 23129 | 58,51% | 12220 | 10,42% |
| | 5,00% | | 5982 | 13,24% | 28174 | 24,02% |
| | 6,00% | | 303 | 0,60% | 36137 | 30,81% |

(continued)

| Transmission Errors | | | Decoder Recovery | | Output ADST Errors | |
|---|---|---|---|---|---|---|
| Dumps ID | Prob. MPEG-TS | Burst Errors | Columns | % | Column | % |
| 2 | 1,00% | 200, 204, 210, 211 | 17229 | 87,74% | 2166 | 1,84% |
| | 2,00% | | 23644 | 87,28% | 2811 | 2,39% |
| | 3,00% | | 27775 | 82,10% | 4554 | 3,88% |
| | 4,00% | | 23143 | 57,95% | 11819 | 10,06% |
| | 5,00% | | 5524 | 12,12% | 28095 | 23,92% |
| | 6,00% | | 426 | 0,84% | 35619 | 30,32% |
| 3 | 1,00% | 100,104,110,111 | 15803 | 89,21% | 1406 | 1,20% |
| | 2,00% | | 22348 | 87,38% | 2337 | 1,99% |
| | 3,00% | | 28235 | 86,51% | 3088 | 2,63% |
| | 4,00% | | 23955 | 61,51% | 10491 | 8,93% |
| | 5,00% | | 7218 | 16,15% | 26342 | 22,43% |
| | 6,00% | | 874 | 1,75% | 64876 | 55,23% |
| 4 | 1,00% | 50,54,60,61 | 15056 | 87,10% | 2770 | 2.36% |
| | 2,00% | | 20427 | 89,76% | 2845 | 2,42% |
| | 3,00% | | 24579 | 88,11% | 3473 | 2,96% |
| | 4,00% | | 27167 | 83,41% | 4814 | 4,10% |
| | 5,00% | | 27520 | 74,04% | 7505 | 6,39% |
| | 6,00% | | 18391 | 44,37% | 16961 | 14,44% |
| 5 | 1,00% | 100,104,110,111 | 18791 | 89,34% | 2764 | 2,35% |
| | 2.00% | | 25367 | 85,06% | 4214 | 3,59% |
| | 3,00% | | 26483 | 69,99% | 8798 | 7,49% |
| | 4,00% | | 7206 | 16,06% | 26528 | 22,58% |
| | 5,00% | | 189 | 0,37% | 36266 | 30,87% |
| | 6,00% | | 0 | 0,00% | 40614 | 34,58% |
| 6 | 1,00% | 120,124,130,131 | 20130 | 89,61% | 2832 | 2,41% |
| | 2,00% | | 27147 | 84,07% | 4619 | 3,93% |
| | 3,00% | | 19034 | 46,31% | 15612 | 13,29% |
| | 4,00% | | 997 | 2.04% | 33175 | 28,24% |
| | 5,00% | | 0 | 0,00% | 39052 | 33,25% |
| | 6,00% | | 0 | 0,00% | 43453 | 36,99% |

The next table (Table 3) shows the number of IP packets transmitted by the MPE-iFEC Receiver, i.e. the number of IP packets extracted from the output ADSTs. The total number of IP packets is indicated, that is the number of IP packets the Receiver should transmit in error free conditions. The simulations were performed using four different configurations. The first configuration consists in disabling both Byte and Recovery Mechanisms which is actually the standard configuration according to the state of the art without improvement. The second configuration enables the Byte Recovery Mechanism, the third one the Address Recovery Mechanism and the last one both Byte and Address Recovery Mechanisms. The different results show that the Byte Recovery Mechanism already improves the performance. The Address Recovery Mechanism brings even more performance. The maximum performance is obtained when both mechanisms are enabled, i.e. when both techniques are operating together.

The following table 3 shows simulation results, namely the number of IP packets transmitted by the MPE-iFEC receiver.

| | Transmission Errors | | | IP packets transmitted by the Receiver (#) | | | |
|---|---|---|---|---|---|---|---|
| Dumps ID | Prob. MPEG-TS | Burst Errors | Total | Off | Byte | Address | Both |
| 1 | 1,00% | 160,164,170,171 | 38172 | 37995 | 38001 | 38137 | 38156 |
| | 2,00% | | | 35933 | 36001 | 37474 | 37651 |
| | 3,00% | | | 30268 | 30457 | 35588 | 36479 |
| | 4,00% | | | 9181 | 9833 | 28134 | 32158 |
| | 5,00% | | | 1645 | 2154 | 16817 | 27594 |
| | 6,00% | | | 1042 | 1466 | 12574 | 25835 |
| 2 | 1,00% | 200,204,210,211 | 38261 | 37698 | 37717 | 38140 | 38215 |
| | 2,00% | | | 34947 | 35042 | 37011 | 37307 |
| | 3,00% | | | 31574 | 31727 | 35705 | 36595 |
| | 4,00% | | | 10341 | 11009 | 28260 | 32363 |
| | 5,00% | | | 1629 | 2152 | 16605 | 27620 |
| | 6,00% | | | 1046 | 1483 | 12483 | 25833 |
| 3 | 1,00% | 100,104,110,111 | 37895 | 36524 | 36548 | 37159 | 37237 |
| | 2,00% | | | 35285 | 35325 | 36579 | 36489 |
| | 3,00% | | | 34219 | 34272 | 35983 | 36548 |
| | 4,00% | | | 18640 | 18973 | 28243 | 32166 |
| | 5,00% | | | 3397 | 3899 | 16755 | 27252 |
| | 6,00% | | | 889 | 1292 | 12088 | 25311 |
| 4 | 1,00% | 50,54,60,61 | 21989 | 21847 | 21856 | 21957 | 21973 |
| | 2,00% | | | 21812 | 21824 | 21936 | 21964 |
| | 3,00% | | | 20611 | 20670 | 21381 | 21533 |
| | 4,00% | | | 18912 | 19016 | 20570 | 20994 |
| | 5,00% | | | 15087 | 15337 | 18809 | 19906 |
| | 6,00% | | | 3863 | 4412 | 12749 | 16320 |
| 5 | 1,00% | 100,104,110,111 | 48178 | 47648 | 47661 | 48117 | 48151 |
| | 2,00% | | | 41901 | 42018 | 46062 | 46641 |
| | 3.00% | | | 21824 | 22401 | 40865 | 43811 |
| | 4,00% | | | 1670 | 2201 | 22961 | 35714 |
| | 5,00% | | | 872 | 1296 | 16179 | 32853 |
| | 6,00% | | | 645 | 1041 | 12971 | 30634 |
| 6 | 1,00% | 120,124,130,131 | 64941 | 64222 | 64233 | 64853 | 64903 |
| | 2,00% | | | 54914 | 55055 | 61757 | 62724 |
| | 3,00% | | | 7168 | 7856 | 45341 | 54444 |
| | 4,00% | | | 1392 | 1885 | 26993 | 47714 |
| | 5,00% | | | 1008 | 1464 | 21179 | 44286 |
| | 6,00% | | | 717 | 1132 | 16996 | 41285 |

The next and last table (Table 4) exposes the improvement of each configuration: Byte Recovery Mechanism alone, Address Recovery Mechanism alone and finally Byte and Address Recovery Mechanisms together. The improvement is computed based on the percentage of IP packets the MPE-iFEC Receiver is capable to send compared to the total number of IP packets it should send in error free condition. The mechanisms increase the number of IP packets extracted from the output ADSTs particularly when they are many errors introduced (i.e. when there are bad channel conditions). The improvement greatly depends on the Receiver parameters: the number of rows "T" influences the interleaving of the IP packets in the table (i.e. on how many columns an IP packet will be spread). When the number of errors become too high one can see that the improvement decreases which is perfectly normal.

Table 4 shows the improvement of the mechanisms according to the simulation results.

| | | Transmission Errors | | Improvement | | |
|---|---|---|---|---|---|---|
| Dumps ID | Prob. MPEG-TS | Burst Errors | | Byte | Address | Both |
| 1 | 1,00% | 160,164,170,171 | | 0,02% | 0,37% | 0,42% |
| | 2,00% | | | 0,18% | 4,04% | 4,50% |
| | 3,00% | | | 0,50% | 13,94% | 16,27% |
| | 4,00% | | | 1,71% | 49,65% | 60,19% |
| | 5,00% | | | 1,33% | 39,75% | 67,98% |
| | 6,00% | | | 1,11% | 30,21% | 64,95% |
| 2 | 1,00% | 200,204,210,211 | | 0,05% | 1,16% | 1,35% |
| | 2,00% | | | 0,25% | 5,39% | 6,17% |
| | 3,00% | | | 0,40% | 10,80% | 13,12% |
| | 4,00% | | | 1,75% | 46,83% | 57,56% |
| | 5,00% | | | 1,37% | 39,14% | 67,93% |
| | 6,00% | | | 1,14% | 29,89% | 64,78% |
| 3 | 1,00% | 100,104,110,111 | | 0,06% | 1,68% | 1,88% |
| | 2,00% | | | 0,11% | 3,41% | 3,18% |
| | 3,00% | | | 0,14% | 4,65% | 6,15% |
| | 4,00% | | | 0,88% | 25,34% | 35,69% |
| | 5,00% | | | 1,32% | 35,25% | 62,95% |
| | 6,00% | | | 1,06% | 29,55% | 64,45% |
| 4 | 1,00% | 50,54,60,61 | | 0,04% | 0,50% | 0,57% |
| | 2,00% | | | 0,05% | 0,56% | 0,69% |
| | 3,00% | | | 0,27% | 3,50% | 4,19% |
| | 4,00% | | | 0,47% | 7,54% | 9,47% |
| | 5,00% | | | 1,14% | 16,93% | 21,92% |
| | 6,00% | | | 2,50% | 40,41% | 56,65% |
| 5 | 1,00% | 100,104,110,111 | | 0,03% | 0,97% | 1,04% |
| | 2,00% | | | 0,24% | 8,64% | 9,84% |
| | 3,00% | | | 1,20% | 39,52% | 45,64% |
| | 4,00% | | | 1,10% | 44,19% | 70,66% |
| | 5,00% | | | 0,88% | 31,77% | 66,38% |
| | 6,00% | | | 0,82% | 25,58% | 62,25% |

(continued)

| | Transmission Errors | | Improvement | | |
|---|---|---|---|---|---|
| Dumps ID | Prob. MPEG-TS | Burst Errors | Byte | Address | Both |
| 6 | 1,00% | 120,124,130,131 | 0,02% | 0,97% | 1,05% |
| | 2,00% | | 0,22% | 10,54% | 12,03% |
| | 3,00% | | 1,06% | 58,78% | 72,80% |
| | 4,00% | | 0,76% | 39,42% | 71,33% |
| | 5,00% | | 0,70% | 31,06% | 66,64% |
| | 6,00% | | 0,64% | 25,07% | 62,47% |

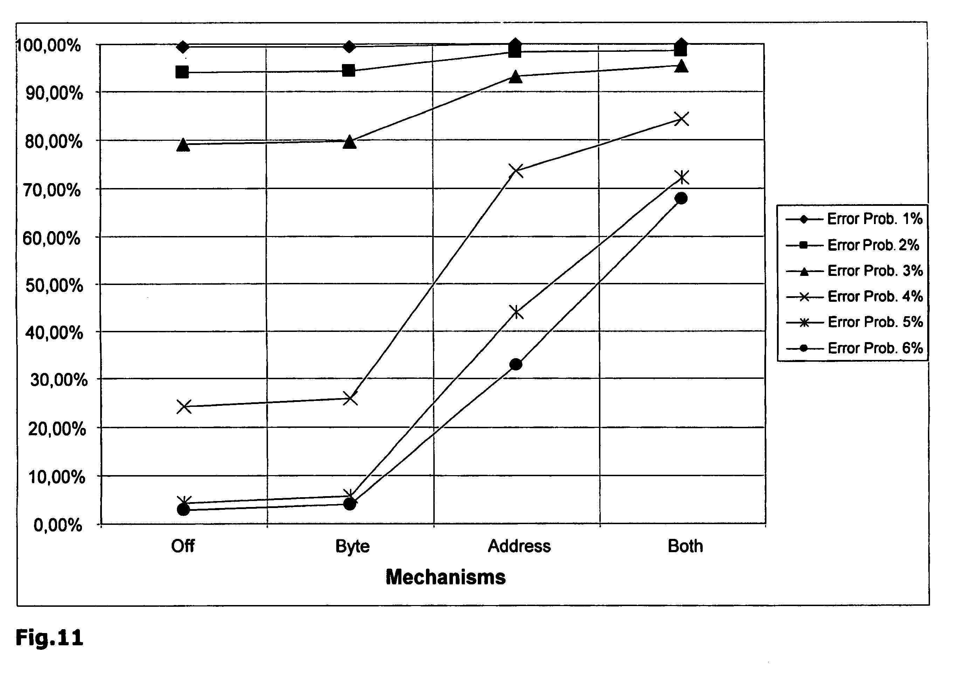

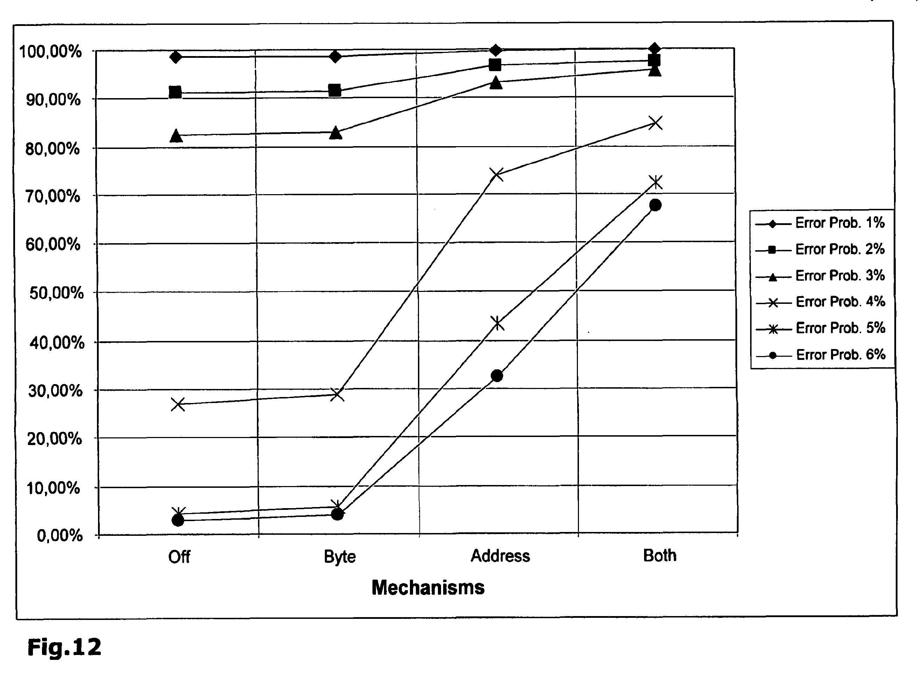

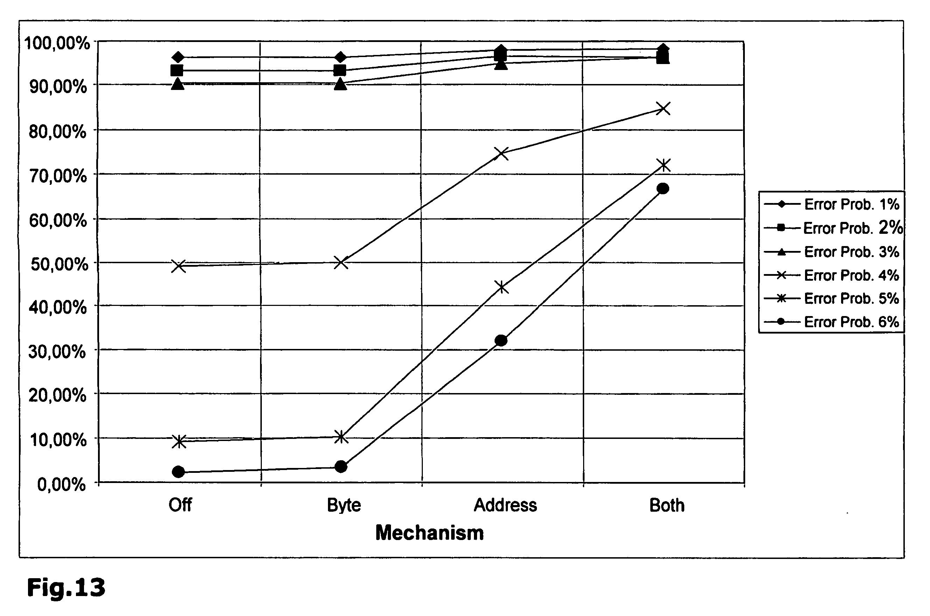

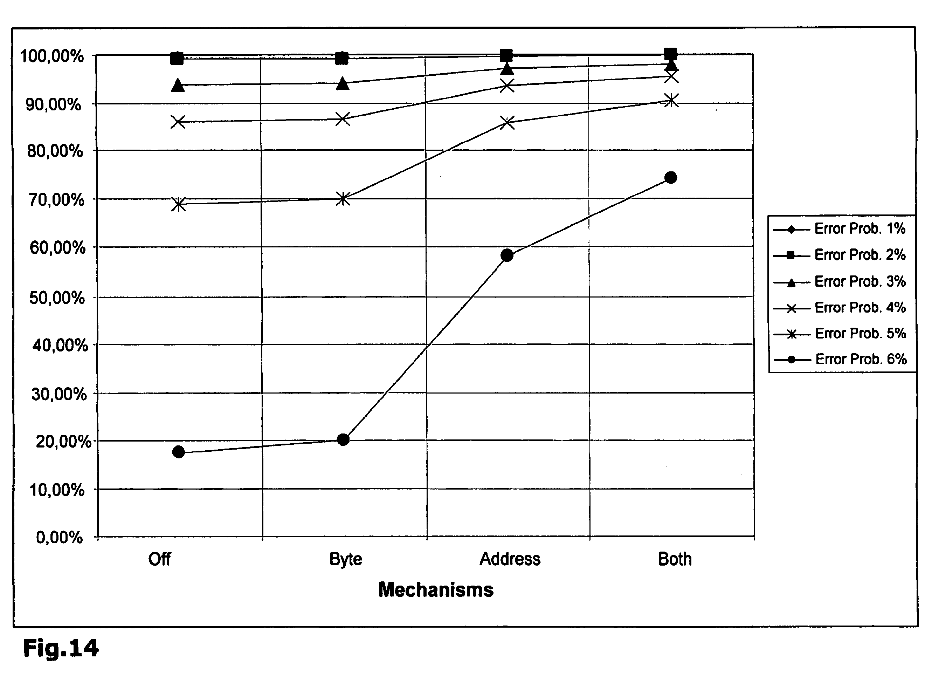

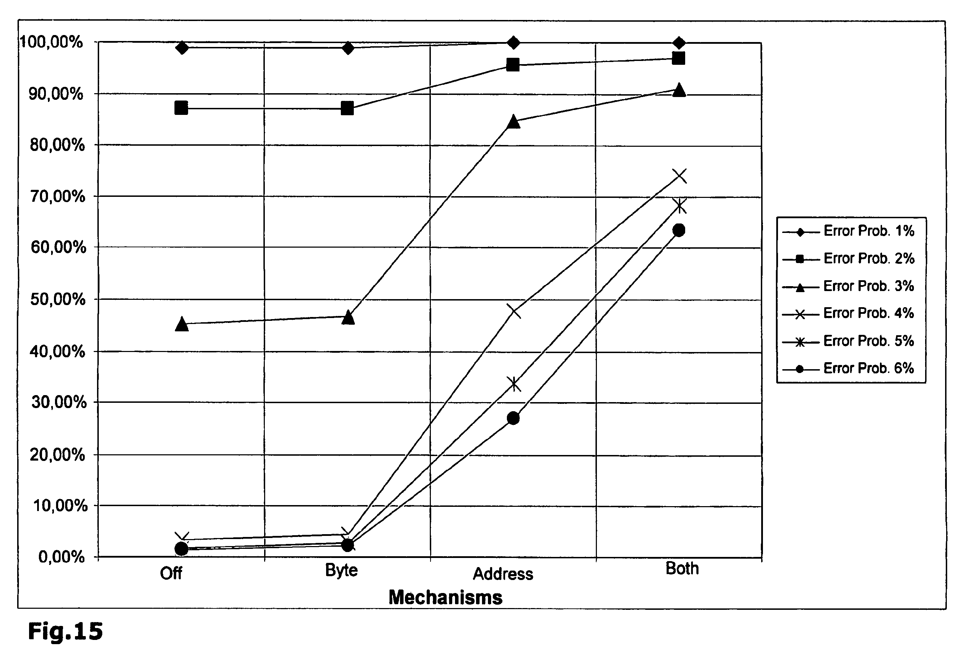

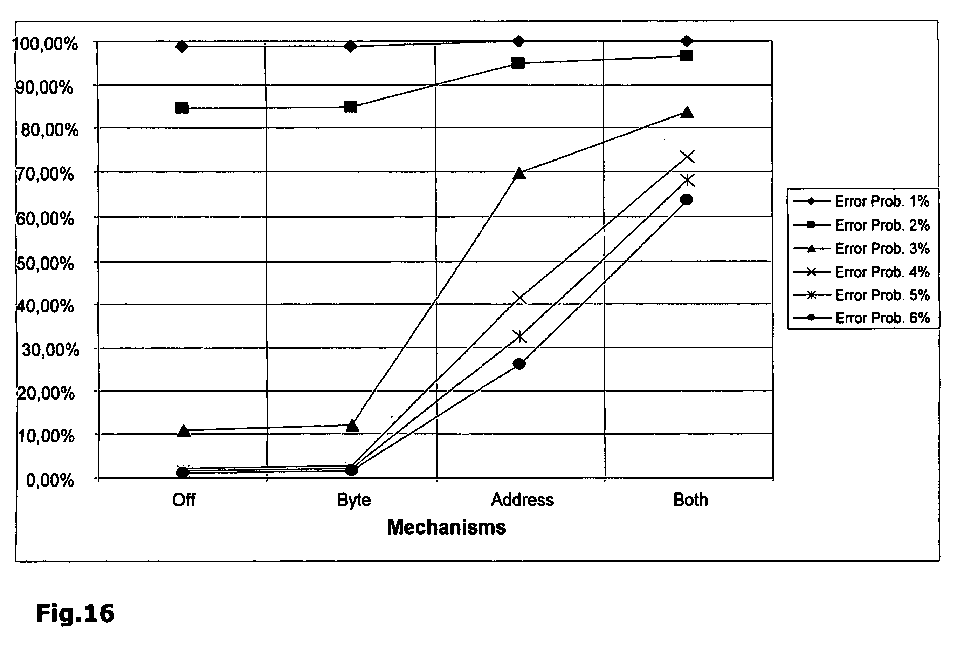

The graphs according to figures 11-16 show the same simulation results as described in connection with the tables.

## Claims

1. Method of transmitting data from a transmitter to a receiver, in particular in a DVB-scenario,
whereby data is transmitted in consecutive bursts and each burst comprises a plurality of Multi-Protocol Encapsulation and Multi-Protocol Encapsulation-inter-burst-Forward Error Correction sections,
whereby MPE-sections carry an APPLICATION DATA SUB-TABLE-address containing the position in the Application Data Sub-Table into which the content of the respective MPE-section has to be written
whereby
this APPLICATION DATA SUB-TABLE-address and the status of each byte is stored into the APPLICATION DATA SUB-TABLE while mapping the content of a burst in the APPLICATION DATA SUB-TABLE and Inter-Burst Forward Error Correction Data Sub-Table, whereby the status of each byte is marked as "error free" or "with errors",
this APPLICATION DATA SUB-TABLE-address and the byte status is further written in the APPLICATION DATA TABLE's while mapping the content of the APPLICATION DATA SUB-TABLE into APPLICATION DATA TABLE's, so that the APPLICATION DATA SUB-TABLE-address and the byte status is conveyed from the APPLICATION DATA SUB-TABLE to the APPLICATION DATA TABLE's,
after the decoding process is applied on the APPLICATION DATA TABLE's and Inter-Burst Forward Error Correction Data Sub-Table's, the byte status stored in the APPLICATION DATA TABLE's is updated by the receiver, by the following steps:

   - Checking whether a byte which has been labeled before decoding as "with errors" is present in a column whose status has changed from "with errors" before decoding to "error free" after decoding
   - Changing the status of such a byte from "with errors" to "error free",

the method further comprising the step:

   - Copying the updated byte status and the APPLICATION DATA SUB-TABLE-address stored in the APPLICATION DATA TABLE's into the output APPLICATION DATA SUB-TABLE's.

2. Method of transmitting data according to claim 1, **characterized in that** while processing an output APPLICATION DATA SUB-TABLE the receiver checks the status of each byte, whereby if all bytes belonging to a data packet are "error free" the receiver starts processing this packet and if at least one byte belonging to a data packet is "with errors", the data packet is discarded, **a data packet comprising multi-protocol encapsulation sections containing data and multi-protocol encapsulation Inter-Burst Forward Error Correction Sections containing redundancy.**

3. Method of transmitting data according to one of claims 1 or 2, **characterized in that** all byte status are marked as "with errors" when initializing the APPLICATION DATA SUB-TABLE and if a byte is mapped from a burst in the APPLICATION DATA SUB-TABLE the corresponding byte is marked as "error free".

4. Method of transmitting data according to one of claims 1-3, **characterized in that** the receiver while processing an output APPLICATION DATA SUB-TABLE starts processing a first data packet and moves its pointer to the address of the next data packet, if the length of the first data packet cannot be computed, whereby for moving the pointer to the address of the next data packet the address information present in the output APPLICATION DATA SUB-TABLE is used, so that the receiver can continue processing the content of the output APPLICATION DATA SUB-TABLE at the address of the next data packet whose address is available.

5. Method of transmitting data according to one of claims 1-4, **characterized in that** the output APPLICATION DATA SUB-TABLE's contain in each column a list of addresses comprising one or more addresses of the respective first byte of data packets beginning in this column or no address, when no first byte of any data packet is present in this column.

6. Method of transmitting data according to one of claims 1-5, **characterized in that** the data part of a burst is not necessarily completely filled and thus can contain a padding, namely a data free area at the end of the APPLICATION DATA SUB-TABLE.

**Patentansprüche**

1. Verfahren zum Übertragen von Daten von einem Sender zu einem Empfänger, insbesondere in einem DVB-Scenario, wobei Daten in aufeinanderfolgenden Bursts übertragen werden und jedes Burst mehrere Multi-Protocol-Encapsulation- und Multi-Protocol-Encapsulation-Inter-burst-Forward-Error-Correction-Abschnitte aufweist, wobei MPE-Abschnitte eine APPLICATION DATA SUB-TABLE-Adresse mitführen, welche diejenige Position in der Application Data Sub-Table enthält, in die der Inhalt des jeweiligen MPE-Abschnitts geschrieben werden soll, wobei

diese APPLICATION DATA SUB-TABLE-Adresse und/oder der Status jedes Bytes in der APPLICATION DATA SUB-TABLE gespeichert werden, während der Inhalt eines Bursts in die APPLICATION DATA SUB-TABLE und die Inter-Burst Forward Error Correction Data Sub-Table abgebildet wird, wobei der Status jedes Bytes als "fehlerfrei" oder "fehlerhaft" markiert wird,

diese APPLICATION DATA SUB-TABLE-Adresse und der Byte-Status ferner in die APPLICATION DATA TABLEs geschrieben werden, während der Inhalt der APPLICATION DATA SUB-TABLE in APPLICATION DATA TABLEs abgebildet wird, so dass die APPLICATION DATA SUB-TABLE-Adresse und der Byte-Status aus der APPLICATION DATA SUB-TABLE zu den APPLICATION DATA TABLEs übertragen werden,

nach Anwendung des Dekodiervorgangs an den APPLICATION DATA TABLEs und den Inter-Burst Forward Error Correction Data Sub-Tables der in den APPLICATION DATA TABLEs gespeicherte Byte-Status durch die folgenden Schritte mittels des Empfängers aktualisiert wird:

- Prüfen, ob ein Byte, das vor dem Dekodieren als "fehlerhaft" markiert worden ist, in einer Spalte vorhanden ist, deren Status sich von "fehlerhaft" vor dem Dekodieren zu "fehlerfrei" nach dem Dekodieren geändert hat,
- Ändern des Status eines derartigen Bytes von "fehlerhaft" zu "fehlerfrei",

wobei das Verfahren ferner folgenden Schritt aufweist:

- Kopieren des aktualisierten Byte-Status und der APPLICATION DATA SUB-TABLE-Adresse, die in den APPLICATION DATA TABLEs gespeichert sind, in die Ausgangs-APPLICATION DATA SUB-TABLEs.

2. Datenübertragungsverfahren nach Anspruch 1, **dadurch gekennzeichnet, dass** während des Verarbeitens einer Ausgangs-APPLICATION DATA SUB-TABLE der Empfänger den Status jedes Bytes prüft, wobei, falls sämtliche zu einem Daten-Paket gehörende Bytes "fehlerfrei" sind, der Empfänger mit dem Verarbeiten dieses Pakets beginnt, und, falls mindestens ein zu einem Daten-Paket gehörendes Byte "fehlerhaft" ist, das Daten-Paket verworfen wird, wobei ein Daten-Paket Multi-Protocol-Encapsulation-Abschnitte, die Daten enthalten, und Multi-Protocol-Encapsulation-Interburst-Forward-Error-Correction-Abschnitte aufweist, die eine Redundanz enthalten.

3. Datenübertragungsverfahren nach einem der Ansprüche 1 oder 2, **dadurch gekennzeichnet, dass** beim Initialisieren der APPLICATION DATA SUB-TABLE sämtliche Byte-Status als "fehlerhaft" markiert sind, und, falls ein Byte aus einem Burst in die APPLICATION DATA SUB-TABLE abgebildet wird, das entsprechende Byte als "fehlerfrei" markiert wird.

**4.** Datenübertragungsverfahren nach einem der Ansprüche 1-3, **dadurch gekennzeichnet, dass** der Empfänger während des Verarbeitens einer Ausgangs-APPLICATION DATA SUB-TABLE damit beginnt, ein erstes Daten-Paket zu verarbeiten, und seinen Pointer zu der Adresse des nächsten Daten-Pakets bewegt, falls die Länge des ersten Daten-Pakets nicht berechnet werden kann, wobei zum Bewegen des Pointers zu der Adresse des nächsten Daten-Pakets die in der Ausgangs-APPLICATION DATA SUB-TABLE vorhandene Adress-Information verwendet wird, so dass der Empfänger mit dem Verarbeiten des Inhalts der Ausgangs-APPLICATION DATA SUB-TABLE an der Adresse des nächsten Daten-Pakets fortfahren kann, dessen Adresse verfügbar ist.

**5.** Datenübertragungsverfahren nach einem der Ansprüche 1-4, **dadurch gekennzeichnet, dass** die Ausgangs-APPLICATION DATA SUB-TABLEs in jeder Spalte eine Liste von Adressen aufweisen, die eine oder mehr Adressen des jeweiligen ersten Bytes von Daten-Paketen beginnend in dieser Spalte, oder keine Adresse enthält, wenn in dieser Spalte kein erstes Byte irgendeines Daten-Pakets vorhanden ist.

**6.** Datenübertragungsverfahren nach einem der Ansprüche 1-5, **dadurch gekennzeichnet, dass** der Daten-Teil eines Bursts nicht notwendigerweise vollständig gefüllt ist und somit ein Padding, nämlich einen datenfreien Bereich am Ende der APPLICATION DATA SUB-TABLE enthalten kann.

**Revendications**

**1.** Procédé de transmission de données d'un émetteur à un récepteur, en particulier dans un scénario de la norme DVB, de sorte que les données sont transmises en salves consécutives et que chaque salve comporte une pluralité de segments de Multi-Protocol Encapsulation and Multi-Protocol Encapsulation-inter-burst-Forward Error Correction, de sorte que les segments MPE portent une adresse de APPLICATION DATA SUB-TABLE contenant la position dans la APPLICATION DATA SUB-TABLE dans laquelle le contenu du segment MPE respectif doit être écrit, de sorte que
cette adresse de APPLICATION DATA SUB-TABLE et l'état de chaque octet sont stockés dans la APPLICATION DATA SUB-TABLE tout en configurant le contenu d'une salve dans la APPLICATION DATA SUB-TABLE et dans la Inter-Burst Forward Error Correction Data Sub-Table, de sorte que l'état de chaque octet est étiqueté comme étant « dépourvu d'erreur » ou « comportant des erreurs »,
cette adresse de APPLICATION DATA SUB-TABLE et l'état des octets sont, de plus, écrits dans les APPLICATION DATA TABLES tout en configurant le contenu de la APPLICATION DATA SUB-TABLE dans les APPLICATION DATA TABLES, de sorte que l'adresse de APPLICATION DATA SUB-TABLE et l'état des octets sont acheminés de la APPLICATION DATA SUB-TABLE vers les APPLICATION DATA TABLES,
après que le processus de décodage a été appliqué sur les APPLICATION DATA TABLES et les Inter-Burst Forward Error Correction Data Sub-Tables, l'état des octets stocké dans les APPLICATION DATA TABLES est actualisé par le récepteur au cours des étapes suivantes .

- Vérifier si un octet qui a été étiqueté avant le décodage comme « comportant des erreurs » est présent dans une colonne dont l'état a changé passant de « comportant des erreurs » avant le décodage à « dépourvu d'erreur » après le décodage ;
- Changer l'état d'un tel octet passant de « comportant des erreurs » à « dépourvu d'erreur » ;

le procédé comprenant, de plus, l'étape de :

- Copier dans les APPLICATION DATA SUB-TABLES de sortie l'état de l'octet actualisé et l'adresse de APPLICATION DATA SUB-TABLE stockés dans les APPLICATION DATA TABLES.

**2.** Procédé de transmission de données selon la revendication 1, **caractérisé en ce que** tout en traitant une APPLICATION DATA SUB-TABLE de sortie le récepteur contrôle l'état de chaque octet de sorte que, si tous les octets appartenant à un paquet de données sont « dépourvus d'erreur », le récepteur démarre le traitement de ce paquet et si au moins un octet appartenant à un paquet de données « comporte des erreurs », le paquet de données est écarté, un paquet de données comprenant des segments de multi-protocol encapsulation contenant des données et des segments de multi-protocol encapsulation Inter-Burst Forward Error Correction contenant une redondance.

**3.** Procédé de transmission de données selon la revendication 1 ou 2, **caractérisé en ce que** tous les états d'octet sont étiquetés comme « comportant des erreurs » lors de l'initialisation de la APPLICATION DATA SUB-TABLE et si un octet est configuré à partir d'une salve dans la APPLICATION DATA SUB-TABLE, l'octet correspondant est étiqueté comme « dépourvu d'erreur ».

4.  Procédé de transmission de données selon l'une des revendications 1 à 3, **caractérisé en ce que** le récepteur, tout en traitant une APPLICATION DATA SUB-TABLE de sortie, commence le traitement d'un premier paquet de données et déplace son pointeur vers l'adresse du paquet de données suivant, si la longueur du premier paquet de données ne peut pas être calculée, de sorte que pour déplacer le pointeur ver-s l'adresse du paquet de données suivant, l'information d'adresse présente dans la APPLICATION DATA SUB-TABLE de sortie est utilisée, de sorte que le récepteur peut continuer à traiter le contenu de la APPLICATION DATA SUB-TABLE de sortie au niveau de l'adresse du paquet de données suivant dont l'adresse est disponible.

5.  Procédé de transmission de données selon l'une des revendications 1 à 4, **caractérisé en ce que** les APPLICATION DATA SUB-TABLES de sortie contiennent dans chaque colonne une liste d'adresses comportant une ou plusieurs adresse(s) du premier octet respectif des paquets de données commençant dans cette colonne ou aucune adresse, lorsqu'aucun premier octet de l'un quelconque des paquets de données est présent dans cette colonne.

6.  Procédé de transmission de données selon l'une des revendications 1 à 5, **caractérisé en ce que** la partie données d'une salve n'est pas nécessairement entièrement remplie et, ainsi, peut contenir un remplissage, à savoir une zone dépourvue de données à la fin de la APPLICATION DATA SUB-TABLE.

**Fig.1**

Fig.2

**Fig.3**

MPE section lost

MPE-iFEC section lost

C (ADST)

R (iFDST)

T

Columns status {

„error free"
„error free"
„with errors"
„with errors"
„error free"
„error free"

„error free"
„error free"
„error free"
„error free"
„error free"
„error free"
„with errors"
„error free"

„error free"

Data

Padding

Redundancy

EP 2 369 768 B1

**Fig.4**

EP 2 369 768 B1

Data

Padding

C

T

ADST

"error free"
"error free"
"error free"
"error free"
"error free"

"error free"
"error free"
"with errors"
"error free"
"error free"
"error free"

Columns status

Fig.5

First pointer
position: first IP
packet

Second pointer
position: second
IP packet

Third pointer
position: IP
packet missing

Column
recovered after
decoding

C

T

ADST

Data

Padding

**Fig.6**

Data

Padding

ADST

Byte status

Columns status

"error free"
"error free"
"error free"
"error free"
"error free"

"error free"
"error free"
"With errors"
"error free"
"error free"
"error free"

C

T

Fig.7

Fig.8

Fig.9

Byte status

Addresses

T

@a₁ "error free"
@a₂ "error free" | "With errors" | "error free"
@a₃ "error free" | "error free"
No @ "With errors" | "error free"
No @ "With errors"
@a₄ "error free" | "With errors"

ADST

C

@aₙ,aₙ₊₁ "error free" | "error free" | "error free"
No @ "error free"
No @ "error free" | "error free"
No @ "error free"
No @ "error free"

Padding

Data

EP 2 369 768 B1

**Fig.10**

**Fig.11**

Fig.12

**Fig.13**

**Fig.14**

EP 2 369 768 B1

**Fig.15**

EP 2 369 768 B1

Fig.16

## REFERENCES CITED IN THE DESCRIPTION

### Non-patent literature cited in the description

- Digital Video Broadcasting (DVB); DVB specification for data broadcasting. *ETSI EN 301 192 V1.4.2,* April 2008
- Framing structure, channel coding and modulation for digital terrestrial television. *ETSI EN 300 744 V1.6.1,* January 2009
- Framing Structure, channel coding and modulation for Satellite Services to Handheld devices (SH) below 3 GHz. *ETSI EN 302 583 V1.1.1,* July 2007
- Guidelines for Implementation for Satellite Services to Handheld devices (SH) below 3GHz. *ETSI TS 102 584 V1.1.1,* December 2008
- MPE-IFEC, Draft TS 102 772 V1.1.1. DVB BlueBook. November 2008
- MPE-IFEC, Draft TS 102 772 V1.1.1. DVB BlueBook A131. November 2008
- MPE-IFEC, Draft TS 102 772 VL1.1.1. DVB Blue-Book A131. November 2008
- Digital Video Broadcasting (DVB) MPE-IFEC. *DVB STANDARD,* 01 November 2008, 1-36